# EUROPEAN PATENT APPLICATION

(11) **EP 2 003 750 A2**
(43) Date of publication of application: **17.12.2008**
(21) Application number: 08010060.5
(22) Date of filing: 02.06.2008
(51) Int. Cl.: H01S 5/22

(54) **Laser diode chip and its production method**

(30) Priority: 13.06.2007 JP 2007155838
(71) Applicant: USHIODENKI KABUSHIKI KAISHA, Chiyoda-ku 100 Tokyo (JP)
(72) Inventor: Imai, Yuji, Kanzaki-gun Hyogo-ken (JP)
(74) Representative: Tomerius, Isabel

(57) **Abstract**

A laser diode chip that yields high irradiance and radiant efficiency, and that emits light having a broad wavelength width and can be used as an element in a light source for an illumination device, and its production method. The laser diode chip has at least a first clad layer, an active layer, and a second clad layer stacked in that order on a substrate, is constructed of a specified combination of constituent materials for the first clad layer, active layer, and second clad layer, and has multiple, parallel, slot-shaped concavities formed in the upper surface of the second clad layer, in each of which a liquid oxide film is baked to form a current arctation layer. Light emitting points are formed in the active layer in each of the light emitting unit areas demarcated by the current arctation layers, the maximum depth of which is 5.0 µm or less.

## Description

### Background of the Invention

### Field of Invention

This invention concerns a laser diode chip and its production method. More specifically, the invention is directed to a laser diode chip that is well suited as a constituent member of a light source in illumination devices, and to a method of producing such a laser diode chip.

### Description of Related Art

In recent years, LED devices used as light sources for lighting devices or the like have had LED chips formed of stacked semiconductor layers, for example, an n-type semiconductor layer, a light emitting layer, and a p-type semiconductor layer stacked in that order on a substrate, with a surface emission structure in which the light generated in the light emitting layer of the LED chip is radiated in the direction of the thickness of the LED chip; that is, it is radiated to the outside after passing through the p-type semiconductor layer or the n-type semiconductor layer and the substrate.

Thus, light generated in the light emitting layer of an LED chip in an LED device is radiated to the outside via other constituent layers, and so the intensity of the light is diminished in the process of passing through the other constituent layers.

On the other hand, in laser diode (LD) devices that have LD chips constructed with at least a first clad layer, an active layer, and a second clad layer stacked in that order on a substrate, have an end-facet emission structure in which the light generated in the active layer of the LD chip is released to the outside from a surface that is the end facet of the active layer; the light generated in the active layer can be released directly to the outside from the active layer without passing through other constituent layers, and so it is possible to obtain a radiant efficiency ten or more times that of an LED device.

A certain type of LD chip has been proposed, for the purpose of obtaining higher radiant efficiency , that has a construction in which a current arctation layer is formed to confine the light generated in spatially limited regions of the active layer, and that has an annealed liquid oxide film instead of a semiconductor layer formed by the epitaxial crystal growth method (Japanese Pre-grant Patent Document 2006-253235).

However, because wavelength width of the light emitted by the LD chip is narrow, with a full width at half maximum value of 0.1 to 1 nm (1 to 10 Å), its use in combination with materials, such as fluorophors, as constituent materials of light sources for lighting devices is sometimes problematic in relation to the wavelength region in which those materials function adequately, and so it is not easy to use the LD chips as constituent members of light sources for lighting devices.

### Summary of the Invention

This invention is based on the situation described above, and has the purpose of providing a laser diode chip that yields high irradiance and high radiant efficiency, and that can emit light having a broad wavelength width and that can, accordingly, be used as a constituent element in a light source for an illumination device, and to a method for its production.

The laser diode chip of this invention has at least a first clad layer, an active layer, and a second clad layer stacked in that order on a substrate, being constructed of any of
a construction in which the first clad layer is an n-type AlGaAs semiconductor, the active layer is an AlGaAs semiconductor, and the second clad layer is a p-type AlGaAs semiconductor,
a construction in which the first clad layer is an n-type AlGaInP semiconductor, the active layer is a GaInP semiconductor, and the second clad layer is a p-type AlGaInP semiconductor, or
a construction in which the first clad layer is an n-type AlGaN semiconductor, the active layer is a GaInP semiconductor, and the second clad layer is a p-type AlGaN semiconductor,
having multiple, parallel, slot-shaped concavities formed in the upper surface of the second clad layer, in each of which a liquid oxide film is annealed to become a current arctation layer, with light emitting points being formed in the active layer in each of the light emitting unit areas demarcated by these multiple current arctation layers,
the maximum depth of the current arctation layers being 5.0 µm or less.

In the laser diode chip of this invention, the full width at half maximum value of the light emitted is from 1 to 50 nm.

The laser diode chip production method of this invention yields a laser diode chip that has at least a first clad layer, an active layer, and a second clad layer stacked in that order on a substrate, being constructed of any of
a construction in which the first clad layer is an n-type AlGaAs semiconductor, the active layer is an AlGaAs semiconductor, and the second clad layer is a p-type AlGaAs semiconductor,
a construction in which the first clad layer is an n-type AlGaInP semiconductor, the active layer is a GaInP semiconductor, and the second clad layer is a p-type AlGaInP semiconductor, or
a construction in which the first clad layer is an n-type AlGaN semiconductor, the active layer is a GaInP semiconductor, and the second clad layer is a p-type AlGaN semiconductor,
in which the laminate stack of at least a first clad layer, an active layer, and a second clad layer stacked in that order on a substrate undergoes the processes of forming multiple, parallel, slot-shaped concavities the upper surface of the second clad layer by etching, forming a liquid oxide film in each of the multiple slot-shaped concavities, and annealing and smoothing the liquid oxide film to form multiple current arctation layers having a depth not exceeding 0.5 µm, by which means light emitting points are formed in the active layer in each of the light emitting unit areas demarcated by the multiple current arctation layers.

Using the laser diode chip of this invention, the constituent materials of the first clad layer, active layer, and second clad layer stacked on the substrate comprise specified combinations, multiple current arctation layers are formed, and the multiple current arctation layers are annealed liquid oxide layers and have a specified maximum depth, and so multiple light emitting unit areas are demarcated, by which means light emitting points are formed in the multiple light emitting unit areas and light is emitted by these multiple light emitting points. Because of that, great irradiance be obtained, a double-heterodyne structure in which the active layer is sandwiched between the first clad layer and the second clad layer that have a lower index of refraction than the active layer is formed in each of the multiple light emitting unit areas, and the current arctation layers that are annealed liquid oxide films have a relatively low index of refraction. Therefore, the light emitted can be adequately confined in specified regions in the active layer, and so a high radiant efficiency is available and the light released has a broad wavelength width.

Consequently, the laser diode chip of this invention is one that yields a great irradiance and high radiant efficiency , and the light it releases has a large wavelength width. Therefore, it can be more freely combined with materials that are fully functional in specified wavelength regions that are used as constituent materials in light sources for lighting devices, and so it is well suited to use as a constituent member in light sources for lighting devices.

Using the laser diode chip production method of this invention, it is possible to form multiple current arctation layers simultaneously, and the current arctation layers can be obtained by annealing liquid oxide layers and smoothing the annealed layers. Therefore, there is no need for the precision control of layer thickness that is necessary when a semiconductor current arctation layer is formed by the epitaxial crystal growth method, and so laser diode chips with good irradiance, high radiant efficiency , and a broad wavelength width of emitted light can be produced easily with a high yield.

### Brief Description of the Drawings

Figure 1 is an explanatory drawing that shows an example of the laser diode chip of this invention.

Figure 2 is an explanatory drawing that shows an expanded view of one light emitting unit area, a key part in the laser diode chip of Figure 1.

Figure 3 is an explanatory drawing that shows an example of the construction of the laminate stack that is fabricated in order to obtain the laser diode chip of Figure 1.

Figure 4 is an explanatory drawing that shows the state of the laminate stack of Figure 3 after formation of concavities for the current arctation layer.

Figure 5 is an explanatory drawing that shows the state of the laminate stack with concavities for the current arctation layer of Figure 3 following formation of the current arctation layer.

Figure 6 is a graph showing the relationship between the maximum depth of the current arctation layer and the half-width value of the light emitted in embodiment examples 1 through 4.

### Detailed Description of the Invention

This invention is explained in detail below.

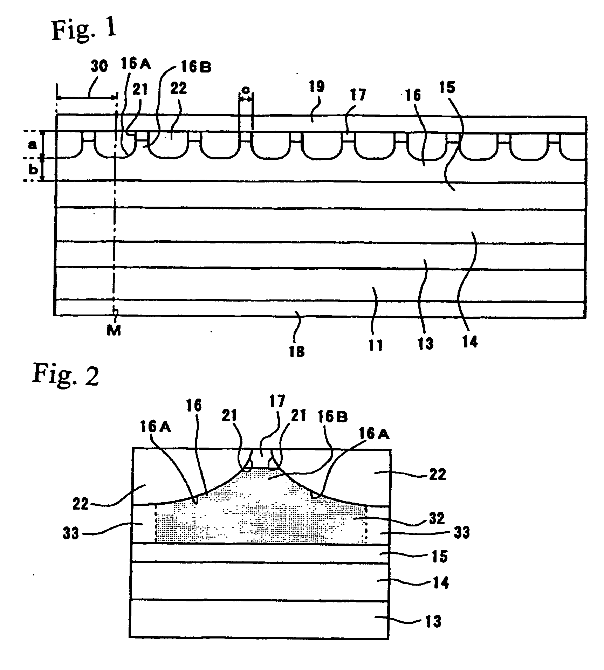

Figure 1 is an explanatory drawing that shows one example of the construction of the laser diode chip of this invention.

In this laser diode chip (LD chip), a buffer layer 13 that is an n-type GaAs semiconductor, for example, is formed on the upper surface (upward in Figure 1) of a substrate 11 that is an n-type GaAs semiconductor, for example, and a first clad layer 14, an active layer 15, and a second clad layer 16 are stacked in that order atop the buffer layer 13; multiple (there are 11 in Figure 1), parallel, slot-shaped concavities 16A are formed on the upper surface (upward in Figure 1) of the second clad layer 16 and a cap layer 17 of p-type GaAs semiconductor is formed on the regions where the slot-shaped concavities 16A are not formed. Current arctation layers 22 are set in current arctation layer concavities 21 that are formed by the slot-shaped concavities 16A in the second clad layer 16 and the cap layers 17.

In this LD chip, an n electrode 18 comprising, for example, a 50 nm AuGe alloy (gold-germanium alloy) film, a 40 nm Ni (nickel) film, and a 200 nm Au (gold) film is formed on the lower surface (downward in Figure 1) of the substrate 11, and a p electrode comprising, for example, a 50 nm Ti (titanium) film, a 100 nm Pt (platinum) film, and a 200 nm Au film is formed on the upper surface (upward in Figure 1) of the cap layer 17 and the current arctation layer 22.

The constituent materials of the first clad layer 14, active layer 15, and second clad layer 16 of this LD chip make up a specified combination; specifically, they have one of the constructions (A) through (C) below.
(A) A construction in which the first clad layer 14 is an n-type AlGaAs semiconductor, the active layer 15 is an AlGaAs semiconductor, and the second clad layer 16 is a p-type AlGaAs semiconductor;
(B) A construction in which the first clad layer 14 is an n-type AlGaInP semiconductor, the active layer 15 is a GaInP semiconductor, and the second clad layer 16 is a p-type AlGaInP semiconductor; or
(C) A construction in which the first clad layer 14 is an n-type AlGaN semiconductor, the active layer 15 is a GaInP semiconductor, and the second clad layer 16 is a p-type AlGaN semiconductor.

Further, the current arctation layer 22 is the result of annealing a liquid oxide film; it fills the current arctation layer concavities 21, and its upper surface is at the same level as the upper surface of the cap layer 17.

In Figure 1, the current arctation layer 22 is U-shaped in cross section, and extends in the direction perpendicular to the plane of the paper.

The annealed material that forms the current arctation layer 22 is obtained by annealing a liquid oxide film of SOG (spin on glass), for example; its main component is silicon oxide (SiO₂).

The maximum depth of the current arctation layer 22 does not exceed 5.0 µm, and is preferably from 0.05 to 5.0 µm.

If the maximum depth a of the current arctation layer 22 were too great, the half-width value of the light released would be too narrow.

If the maximum depth b of the current arctation layer 22 were less than 0.05 µm, there would insufficient action to confine the light by the current arctation layer 22, the half-width value of the light released would be too great, and laser oscillation might not occur.

The minimum thickness b of the second clad layer 16 that has the slot-shaped concavities 16A in which the current arctation layer 22 is formed is preferably at least 0.2 µm

If the minimum thickness b of the second clad layer 16 were too small, the light-confining action might be inadequate.

In this LD chip, there are multiple (11 in Figure 1) current arctation layers 22; the separation c between adjacent current arctation layers 22 is preferably from 2 to 5 µm.

In the example in Figure 1, the multiple current arctation layers 22 are equally spaced.

In an LD chip with such a construction, multiple (there are 10 in Figure 1) light emitting unit areas 30 are demarcated by the multiple current arctation layers 22; light emitting points are formed in the active layer 15 in each of the multiple light emitting unit areas 30.

In other words, in the LD chip, there are multiple (10 in Figure 1) light emitting points in the shared active layer 15.

The light emitting unit areas 30 have a structure such that adjacent light emitting unit areas 30 include the location of maximum depth in the current arctation layer 22 and are demarcated by a virtual plane M that is perpendicular to each constituent layer of the LD chip and parallel to the current arctation layers 22 as a boundary, and current arctation layers 22 formed in adjacent slot-shaped concavities 16A in the second clad layer 16 face across convexities 16B that are mountain-shaped in cross section.

In Figure 1, a virtual plane M is shown in cross section by a long-and-short dashed line.

As shown in Figure 2, a port portion is formed in the light emitting unit area 30 by the cap layer 17 that is formed atop the convexity 16B in the second clad layer 16 between adjacent current arctation layers 22. Within the second clad layer 16, a current application layer 32 is formed in the direction of thickness (the up/down direction in Figure 1) in the region that is below the port portion and between adjacent current arctation layers 22, and an intermediate layer 33 is formed on each side of this current application layer 33.

Moreover, within the light emitting unit areas 30, light emitting points are formed in the regions located in active layer 15 below the current application layer 32 (also called "active regions" hereafter).

As an example of the dimensions of the LD chip, the thickness of the substrate 11 is 300 µm, the thickness of the buffer layer 13 is 0.6 µm, the thickness of the first clad layer 14 is 0.7 µm, the thickness of the active layer 15 is 0.1 µm, the maximum thickness of the second clad layer 16 is 1.0 µm, the minimum thickness of the second clad layer is 0.7 µm, the thickness of the cap layer 17 is 0.2 µm, the maximum depth of the current arctation layer 22 is 0.5 µm, and the separation between current arctation layers 22 is 3 µm.

As is explained below using the figures, an LD chip with such a construction can be produced by having the laminate stack of at least a first clad layer 14, an active layer 15, and a second clad layer 16, and a cap 17 stacked in that order on a substrate 11 undergo the processes of forming multiple slot-shaped concavities 21 by etching, forming a liquid oxide film in each of the multiple slot-shaped concavities 21, and annealing and smoothing the liquid oxide film to form multiple current arctation layers 22.

### <Laminate stack formation process>

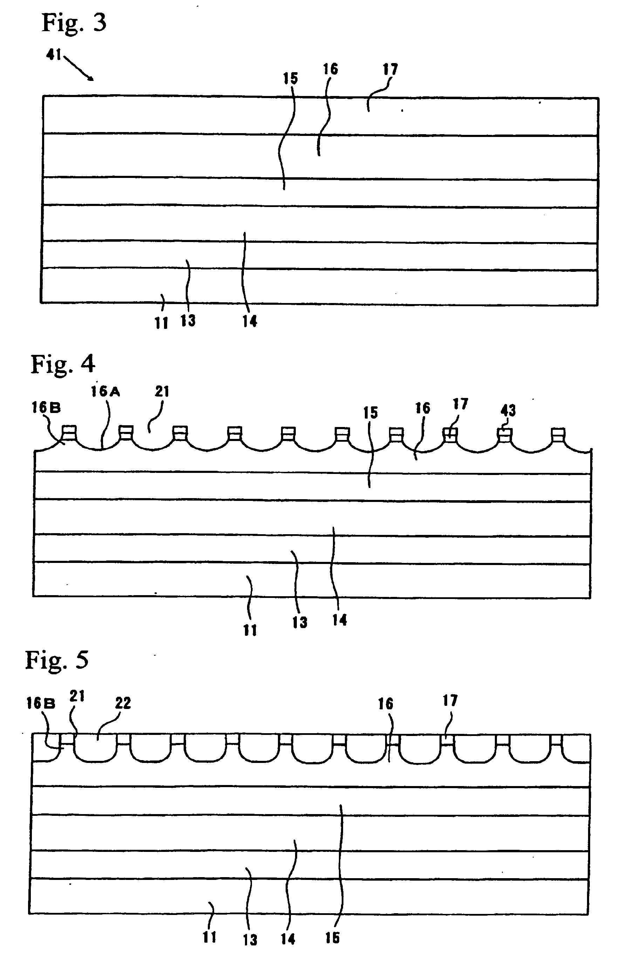

First, the MOCVD method (an organometallic vapor growth method) is used to fabricate a laminate stack 41 constructed by stacking a buffer layer 13, a first clad layer 14, an active layer 15, a second clad layer 16, and a cap layer 17, in that order, on the full surface of a substrate 11, as shown in Figure 3.

### Concavity for current arctation layer formation process

Then, as shown in Figure 4, a protective film 43 is formed on the upper surface of the resulting laminate stack 41 on only the regions (also called "etching protected regions" hereafter) other than the regions where current arctation layer concavities 21 are to be formed, and etching is applied to the laminate stack 41 on which this protected film 43 is formed. By means of etching the cap layer 17 and the second clad layer 16 in regions other than the etching protected regions of the laminate stack 41, the cap layer 17 is patterned and slot-shaped concavities 16A are formed in the second clad layer 16, resulting in the formation of current arctation layer concavities 21.

The method of forming the protective film 43 only over the etching protected regions here is to form a protective film 43 over the full upper surface of the laminate stack 41 by the CVD method (a vapor growth method), for example, then form a photoresist application film over the full upper surface of the protective film 43, repeatedly expose the application film using masks with patterns corresponding to the etching protected regions, and remove the exposed portions with a reagent solution to give the application layer a pattern corresponding to the etching protected regions. It is then possible to use dry etching as a method to remove the protective film 43 formed in regions where no application film is formed, or in other words, in regions other than the etching protected regions.

The etchant is selected as appropriate to the constituent materials of the cap layer 17 and second clad layer 16 to be etched; if the cap layer 17 is a p-type GaAs semiconductor and the second clad layer 16 is a p-type AlGaAs semiconductor, a mixture of sulfuric acid (H₂SO₄) and hydrogen peroxide (H₂O₂) can be used.

The conditions of the etching treatment will depend on the constituent materials of the cap layer 17 and second clad layer 16 to be etched, the depth of the current arctation layer 22 to be formed, and the type and concentration of the etchant, but if the cap layer 17 is a p-type GaAs semiconductor with a thickness of 0.2 µm, the second clad layer 16 is a p-type AlGaAs semiconductor, the maximum depth of the current arctation layer 22 to be formed is 0.5 µm (a maximum depth of 0.3 µm for the slot-shaped concavities 16A to be formed in the second clad layer 16 plus the 0.2 µm thickness of the cap layer 17), and a mixture of sulfuric acid and hydrogen peroxide is to be used as the etchant (with a ratio of sulfuric acid to hydrogen peroxide by volume of 3:1), the etching period could be 15 seconds, for example.

Depending on the conditions of the etching treatment here, there may be a difference in etching speeds, with the speed of etching the cap layer 17 about three times the speed of etching the second clad layer 16, and so it is possible to make use of that difference to use a single etching treatment to etch the regions of the cap layer 17 other than the etching protected regions as well as a part of the regions of the second clad layer 16 other than the etching protected regions, and so the treatment itself is simplified.

Further, it is possible to take advantage of the slower etching speed of the second clad layer 16 to give a gentle slope to the surface of the slot-shaped concavities 16A, and so it is possible, by giving the slot-shaped concavities 16A such a shape, to prevent the occurrence of current disruption in the LD chip that is ultimately obtained.

### Current arctation layer formation process

Then, a rotary applicator, for example, is used to apply a liquid oxide film formation liquid to the laminate stack 41 on which current arctation layer concavities 21 are formed, so that the current arctation layer concavities 21 are filled in and the protective film 43 is covered. A liquid oxide film is formed by this means, and by annealing treatment of this liquid oxide film in, for example, a mixed gas atmosphere comprising hydrogen gas and nitrogen gas with a hydrogen gas concentration from 1 to 5 vol%, the liquid oxide film is annealed and an annealed layer is formed.

Next, the laminate stack 41 on which the annealed layer is formed is etched with a mixed gas comprising carbon tetrafluoride (CF₄) gas and oxygen gas, by which means a portion of the annealed layer is removed to expose the protective film 43, and its upper surface is smoothed to the same level as the upper surface of the cap level 17. By further etching away the exposed protective layer 43, current arctation layers 22 are formed in the current arctation layer concavities 21, as shown in Figure 5.

SOG (spin on glass) is ideally used as the liquid oxide film formation liquid.

With regard to the conditions of the annealing treatment, the annealing temperature is normally from 150 to 500 °C and the annealing treatment period is from 20 to 70 minutes.

### Electrode fabrication process

The LD chip is produced from the laminate stack 41 with current arctation layers 22 formed in the current arctation layer concavities 21 by using suitable methods to form an n electrode 18 on the lower surface of the substrate 11 and a p electrode 19 on the upper surfaces of the cap layers 17 and the current arctation layers 22.

When a voltage is applied between the n electrode 18 and the p electrode 19 of an LD chip with such a construction, current will flow in the active layer 15, but the current flowing in this active layer 15 is limited by the current arctation layers 22 and concentrated in active regions positioned below the current application layers 32 of the second clad layer 16. As a result, the carriers (electrons and holes) injected into the active layer 15 by the current are concentrated in the active regions, so that the carriers in these active regions unite and produce light; light emitting points are formed, and the light generated is confined in the active regions. Then the threshold current is exceeded and laser oscillation begins, by which means light is released in the outward direction (the direction perpendicular to the plane of the paper in Figure 1) from the surface that is the end facet of the active layer 15.

In this LD chip, therefore, there are a first clad layer 14, an active layer 15, and a second clad layer 16 stacked a substrate 11 that have a specified combination of constituent materials, there are multiple current arctation layers 22, which multiple current arctation layers 22 are annealed liquid oxide film having a specified maximum depth. Therefore, multiple light emitting unit areas 30 are demarcated by the current arctation layers 22, by which means light emitting points are formed in each of the multiple light emitting unit areas 30 and light is produced by these multiple light emitting points. Therefore, great irradiance is available; a double-heterodyne structure in which the active layer 15 is sandwiched between the first clad layer and the second clad layer 16 that have a lower index of refraction than the active layer 15 is formed in each of the multiple light emitting unit areas 30, and the current arctation layers 22 that are annealed liquid oxide films have a relatively low index of refraction of about 1.4. Therefore, the light emitted can be adequately confined in specified regions in the active layer, and so a high radiant efficiency is available and the light released has a broad wavelength width.

The light released by this LD chip has a broad wavelength width; specifically, the full width at half maximum value is from 1 to 50 nm.

The wavelength width of the light released by this LD chip can be controlled by adjusting the maximum depth a of the current arctation layers 22.

Consequently, the LD chip of this invention is one that yields a great irradiance and high radiant efficiency, and the light it releases has a large wavelength width. Therefore, it can be more freely combined with materials such as fluorophors that are fully functional in specified wavelength regions that are used as constituent materials in light sources for lighting devices, and so it is well suited to use as a constituent member in light sources for lighting devices.

The LD chips with such a construction of this invention are obtained by having the laminate stack of a first clad layer 14, an active layer 15, and a second clad layer 16, and a cap 17 stacked in that order on the full surface of a substrate 11 undergo the processes of forming multiple slot-shaped concavities 21 by etching, forming a liquid oxide film in each of the multiple slot-shaped concavities 21, and annealing and smoothing the liquid oxide film to form multiple current arctation layers 22. In producing these LD chips, it is possible to form multiple current arctation layers 22 simultaneously, and there is no need for the precision control of layer thickness that is necessary when a semiconductor current arctation layer is formed by the epitaxial crystal growth method, and so it is possible to produce easily with a high yield.

This invention is not limited to the mode of embodiment described above; it is possible to add various changes.

### Examples

Specific examples of embodiments of this invention are explained below, but the invention is not limited to them.

### Embodiment example 1

First, a laminate stack having the structure shown in Figure 3 was fabricated by using the MOCVD method to stack a buffer layer of n-type GaAs semiconductor 0.6 µm thick, a first clad layer of n-type AlGaAs semiconductor 0.7 µm thick, an active layer of AlGaAs semiconductor 0.1 µm thick, a second clad layer of p-type AlGaAs 0.1 µm thick, and a cap layer of p-type GaAs semiconductor 0.2 µm thick, in that order, on a substrate of n-type GaAs semiconductor 300 µm thick.

Next, a protective film was formed by the CVD method on the full upper surface of the resultant laminate stack and a photoresist application film was formed on the full upper surface of the protective film. The application film was repeatedly exposed using masks with patterns corresponding to the etching protected regions (the regions other than the regions where current arctation layer concavities were to be formed), and the exposed portions were removed; the result had the application film patterned corresponding to the etching protected regions. Then dry etching was used to remove the protective film formed in regions where no application film was formed (regions other than the etching protected regions), by which means protective film was formed only in the etching protected regions on the upper surface of the laminate stack.

Next, the laminate stack with the protective film formed on it was submerged in an etchant comprising a mixture of sulfuric acid and hydrogen peroxide (with a ratio of sulfuric acid to hydrogen peroxide by volume of 3:1) and etched with an etching treatment temperature of 20 °C and an etching treatment period of 15 minutes, by which means the cap layer and a portion of the second clad layer on the laminate stack were removed in regions other than the etching protected regions. Thus the cap layer was patterned and gently sloping slot-shaped concavities were formed in the second clad layer, so that 11 current arctation layer concavities with a maximum depth of 0.5 µm, parallel and equally spaced with a separation of 3 µm, were formed on the laminate stack.

The laminate stack with 11 current arctation layer concavities formed in this way had a liquid oxide film formed by applying a liquid oxide film formation liquid comprising SOG with a rotary applicator to fill in the current arctation layer concavities and cover the protective film. This liquid oxide film underwent an annealing treatment in a mixed gas atmosphere comprising hydrogen gas and nitrogen gas with a hydrogen gas concentration of 3 vol%, by which means the liquid oxide film was annealed and an annealed layer was formed.

Next, the laminate stack on which the annealed layer was formed had part of the annealed layer removed with a mixed gas comprising carbon tetrafluoride (CF₄) gas and oxygen gas to expose the protective film, and its upper surface was smoothed to the same level as the upper surface of the cap level 17. By further etching away the exposed protective layer, current arctation layers were formed in the current arctation layer concavities (see, Figure 5).

An n electrode 18 comprising a 50 nm AuGe alloy film, a 40 nm Ni film, and a 200 nm Au film was formed on the lower surface of the substrate 1 of the laminate stack with current arctation layers formed in each of the current arctation layer concavities, and a p electrode comprising a 50 nm Ti film, a 100 nm Pt film, and a 200 nm Au film was formed on the upper surface of the cap layers and the current arctation layers. The LD chip (also called the "LD chip (1)" hereafter) was produced by this means.

When 350 mA of current was supplied to the LD chip thus obtained and the intensity of the light released was measured, it was 30 mW.

When the half-width value of the light released was measured, the wavelength peak was at 780 nm and the half-width value was 18 nm.

### Embodiment examples 2 to 4

In embodiment example 1, LED chips in which the maximum depths of the current arctation layers were 0.2 µm, 0.4 µm, 0.8 µm, and 1.6 µm were produced in the same way as in embodiment example 1, except that the etching treatment periods were varied so that the maximum depths of the current arctation layers were 0.2 µm, 0.4 µm, 0.8 µm, and 1.6 µm.

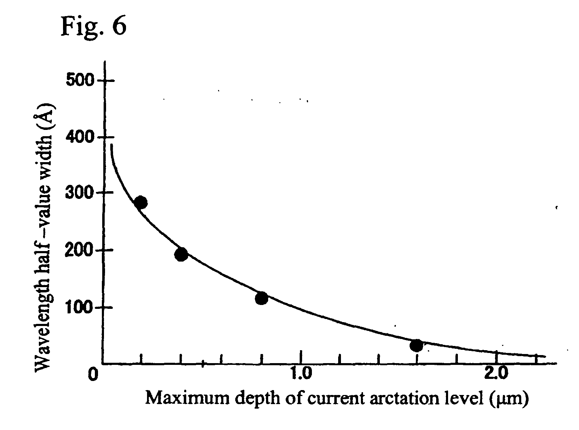

The half-width values of the LED chips obtained were measured in the same way as in embodiment example 1. The results are shown in Figure 6. These results, together with those of embodiment example 1, are shown in Table 1 and Figure 6.

**Table 1**

| | Embodiment example 1 | Embodiment example 2 | Embodiment example 3 | Embodiment example 4 |
|---|---|---|---|---|
| Maximum depth of current arctation layer (µm) | 0.2 | 0.4 | 0.8 | 1.6 |
| Half width value (nm) | 29 | 20 | 12 | 4 |

## Claims

1. A laser diode chip that has at least a first clad layer, an active layer, and a second clad layer stacked in that order on a substrate, being constructed of one of:
a construction in which the first clad layer is an n-type AlGaAs semiconductor, the active layer is an AlGaAs semiconductor, and the second clad layer is a p-type AlGaAs semiconductor,
a construction in which the first clad layer is an n-type AlGaInP semiconductor, the active layer is a GaInP semiconductor, and the second clad layer is a p-type AlGaInP semiconductor, or
a construction in which the first clad layer is an n-type AlGaN semiconductor, the active layer is a GaInP semiconductor, and the second clad layer is a p-type AlGaN semiconductor,
wherein multiple, parallel, slot-shaped concavities have been formed in the upper surface of the second clad layer, in each of which a liquid oxide film has been annealed to become a current arctation layer, with light emitting points being formed in the active layer in each of the light emitting unit areas demarcated by the multiple current arctation layers, and
wherein the maximum depth of the current arctation layers is 5.0 µm or less.

2. A laser diode chip as described in claim 1, wherein the chip is adapted to emit light having a full width at half maximum value of from 1 nm to 50 nm.

3. A laser diode chip production method of producing a laser diode chip that has at least a first clad layer, an active layer, and a second clad layer stacked in that order on a substrate, that is constructed of one of:
a construction in which the first clad layer is an n-type AlGaAs semiconductor, the active layer is an AlGaAs semiconductor, and the second clad layer is a p-type AlGaAs semiconductor,
a construction in which the first clad layer is an n-type AlGaInP semiconductor, the active layer is a GaInP semiconductor, and the second clad layer is a p-type AlGaInP semiconductor, or
a construction in which the first clad layer is an n-type AlGaN semiconductor, the active layer is a GaInP semiconductor, and the second clad layer is a p-type AlGaN semiconductor,
comprising the steps of:
stacking the at least first clad layer, active layer, and second clad layer in that order on a substrate,
forming multiple, parallel, slot-shaped concavities in the upper surface of the second clad layer by etching,
forming a liquid oxide film in each of the multiple slot-shaped concavities formed, and
annealing and smoothing the liquid oxide film to form multiple current arctation layers having a depth not exceeding 0.5 µm, by means of which light emitting points are formed in the active layer in each light emitting unit area demarcated by multiple current arctation layers.
